Europäisches Patentamt

**European Patent Office**

**Office européen des brevets**

(11) Numéro de publication: **0 271 407 B1**

(12) **FASCICULE DE BREVET EUROPEEN**

(45) Date de publication de fascicule du brevet: **01.07.92**  (51) Int. Cl.⁵: **H02B 1/22**, H05K 9/00, H04R 1/02

(21) Numéro de dépôt: **87402770.9**

(22) Date de dépôt: **04.12.87**

(54) **Procédé de protection d'un élément d'installation plongé dans un milieu environnant et sensible aux influences électriques, magnétiques et/ou électromagnétiques présentes dans ce milieu.**

(30) Priorité: **04.12.86 FR 8616995**

(43) Date de publication de la demande:
**15.06.88 Bulletin 88/24**

(45) Mention de la délivrance du brevet:
**01.07.92 Bulletin 92/27**

(84) Etats contractants désignés:
**DE ES GB IT NL**

(56) Documents cités:
**EP-A- 0 161 805       WO-A-85/00245
FR-A- 2 230 043        FR-A- 2 589 024
GB-A- 2 057 297        US-A- 3 836 482**

(73) Titulaire: **Noel, Gérard Philippe Alain
148 Av. du Président Wilson
F-92300 Levallois Perret(FR)**

(72) Inventeur: **Noel, Gérard Philippe Alain
148 Av. du Président Wilson
F-92300 Levallois Perret(FR)**

(74) Mandataire: **CABINET BONNET-THIRION
95 Boulevard Beaumarchais
F-75003 Paris(FR)**

## Description

L'invention concerne d'une manière générale un procédé de protection d'un élément d'installation plongé dans un milieu environnant et sensible aux influences électriques, magnétiques et/ou électromagnétiques présentes dans ce milieu.

Cette invention est une nouvelle étape d'un ensemble de recherches expérimentales du demandeur tendant à améliorer les performances qualitatives de systèmes électro-acoustiques ; les étapes précédentes de ces travaux concernaient la structure d'ensemble de reproduction sonore selon la demande de brevet EP-A-0 225 215.

Les nouveaux développements actuels semblent avoir une portée considérablement élargie laissant entrevoir la possibilité d'applications beaucoup plus vastes à tout système de transport ou de traitement de signaux électriques.

L'invention est basée sur l'hypothèse, pour l'instant entièrement empirique, de la possibilité d'interactions jusqu'à présent mal connues et inexplorées entre éléments de traitement et/ou de transport de signaux électriques, d'une part, et le milieu environnant, en particulier l'air ambiant, d'autre part.

Dans un milieu environnant, tel que l'air ambiant, les molécules de gaz et les éléments en suspension, en particulier les molécules qui présentent un moment électrique permanent et celles qui peuvent présenter un moment électrique induit, sont soumises à l'influence de champs électriques, magnétiques et/ou électromagnétiques inévitablement présents dans ce milieu.

Si pour certaines applications, les effets dûs à ces phénomènes s'avèrent négligeables ou secondaires, dans d'autres applications, en particulier dans les cas de la transmission de signaux audio, ces effets peuvent affecter notablement la restitution et la qualité du son reproduit par des enceintes acoustiques. Le son peut se trouver affecté, d'une part, par des perturbations électriques attribuables à des signaux parasites qui se combinent aux signaux audio véhiculés par le câble aboutissant aux enceintes et, d'autre part, par des perturbations mécaniques qui influencent l'onde acoustique à sa sortie du transducteur électroacoustique.

D'une manière générale, il est classique de recourir dans le domaine électrique à des matériaux isolants pour protéger un corps électriquement conducteur du milieu environnant. Cependant, il n'existe pas d'isolant parfait qui puisse former un écran total de protection contre les influences d'un milieu extérieur et ce, d'autant plus, que l'isolant lui-même semble pouvoir contribuer à ces effets en permettant par exemple l'accumulation de charges statiques.

Il est également connu de mettre en oeuvre des blindages tant autour des câbles de liaison que de certains appareils transducteurs, amplificateurs ou autres, mais l'expérience montre que ces blindages sont en général insuffisants à l'égard des influences indésirables en question et peuvent même contribuer à aggraver celles-ci.

Le but de l'invention est de pallier les influences exercées par un milieu environnant sur un élément d'installation plongé dans ce milieu, en suppléant notamment à l'insuffisance des matériaux isolants et blindages utilisés jusqu'à maintenant dans le domaine électrique.

D'une manière plus précise, l'invention a pour objet un procédé de protection d'un élément d'installation plongé dans un milieu environnant, en particulier l'air ambiant, et sensible aux influences électriques, magnétiques et/ou électromagnétiques de ce milieu, caractérisé par la disposition autour dudit élément d'un enrobage destiné à assurer un drainage des charges électriques tendant à s'y accumuler, cet enrobage étant constitué par application sur l'élément à protéger d'un revêtement en matériau isolant chargé d'un matériau semi-conducteur intrinsèque.

Une telle disposition se distingue notamment de l'objet du document WO-A- 8 500 245 qui comporte un enrobage en matériau faiblement conducteur, à tort qualifié de "semiconducteur" : un tel enrobage antérieur est destiné, en effet, à assurer une mise à la terre continue, alors que le drainage selon l'invention implique une accumulation préalable des charges dans la couche d'enrobage.

La notion de "semi-conducteur" utilisée dans la présente description doit être interprétée, en effet, avec la pleine signification conférée à cette notion, en matière de conduction électrique dans les solides, impliquant notamment l'étroitesse de l'intervalle entre bande de valence et bande de conduction, effets de redresseur et de photoconductivité.

Un tel enrobage peut être constitué par application sur l'élément à protéger d'un matériau isolant chargé d'un matériau semi-conducteur pulvérulent, ladite charge se situant entre 5 et 30 % en poids.

Suivant la nature de l'élément d'installation à protéger, le drainage des charges peut être assuré par le conducteur lui-même dans le cas où l'élément est un fil conducteur, par un conducteur de raccordement à une masse dans le cas où l'élément est une enceinte acoustique, par un organe de décharge dans le milieu ambiant dans le cas où l'élément est un haut-parleur.

Dautres avantages, caractéristiques et détails apparaîtront plus clairement à l'aide de la description explicative qui va suivre faite en référence aux dessins annexés, donnés à titre d'exemple, et dans lesquels :

- la figure 1 est une vue en coupe longitudinale agrandie d'un fil conducteur auquel est appliqué le procédé conforme à l'invention ;
- la figure 2 est une vue en coupe longitudinale agrandie d'un fil conducteur auquel est appliqué une variante du procédé conforme à l'invention ;
- la figure 3 est une vue en coupe longitudinale agrandie illustrant l'application du procédé conforme à l'invention à la zone de raccordement entre deux fils conducteurs.
- la figure 4 est une vue en coupe verticale d'un haut-parleur d'une enceinte auquel est appliqué le procédé conforme à l'invention, et
- la figure 5 est une vue en coupe verticale partielle et simplifiée d'une enceinte à laquelle est appliqué le procédé conforme à l'invention.

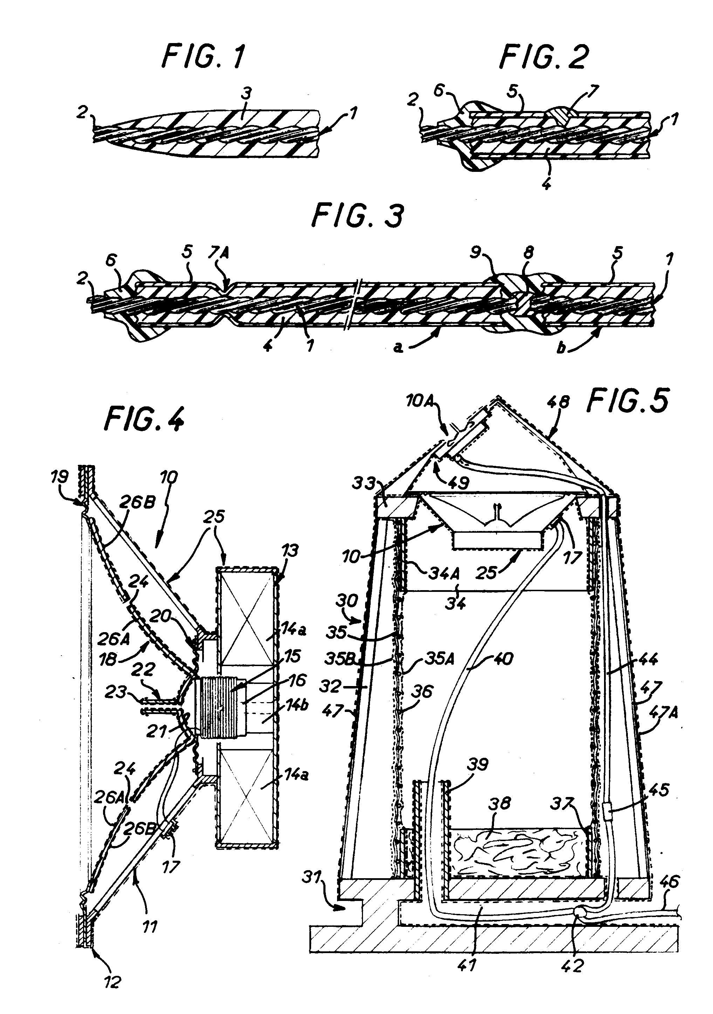

Suivant la forme de réalisation choisie et représentée à la figure 1, l'invention est appliquée à un conducteur nu tout au long de la surface de ce conducteur, en l'occurence un fil multibrins 1, sauf sur les parties d'extrémité 2 destinées aux connections, on a déposé par enduction un enrobage 3 en polyvinylchloroéthylène (PVC) chargé d'environ 15% en poids d'oxyde cuivreux.

Le mélange est préparé alors que le produit de revêtement est encore à l'état liquide.

Le produit de revêtement conserve, malgré sa charge en matériau semi-conducteur pulvérulent qu'est l'oxyde cuivreux, son caractère électriquement isolant. Cependant le comportement du conducteur se trouve modifié en courant alternatif, en particulier aux fréquences audio : l'analyse de ce comportement reste encore à explorer tant sur le plan expérimental que théorique, mais les résultats empiriques déjà accumulés établissent une modification des conditions d'interaction avec le milieu ambiant.

Dans le cas particulier d'un conducteur en cuivre, de telles modifications ont même été notées sous l'effet d'une simple oxydation de la couche superficielle dudit conducteur en oxyde cuivreux en l'absence d'un liant isolant: sans doute convient-il de considérer la modification de l'effet pelliculaire dans les conditions de circulation de courants alternatifs, mais l'exploration reste à développer.

Quoiqu'il en soit, dans le cas général, un enrobage selon l'invention sera constitué à base d'un liant isolant avec dispersion préalable dans celui-ci d'une charge de matériau semi-conducteur pulvérulent.

Comme exemples de liant isolant de base on peut citer, outre le PVC, le polyéthylène, le silicone, le polytétrafluoroéthylène (PTFE).

Comme matériaux semi-conducteurs on peut utiliser, semble-t-il tous semi-conducteurs intrinsèques tels que sélénium, germanium, sulfure de plomb, oxydes de fer etc..

Quant à la quantité de charge de semi-conducteur pulvérulent à disperser dans le matériau isolant liant de base, l'expérience acquise à ce jour conduit à préconiser des proportions comprises entre 5 et 30 pourcents en poids.

En ce qui concerne l'épaisseur de l'enrobage disposé selon l'invention sur le conducteur à protéger, elle a été conditionnée dans les essais effectués à ce jour par les techniques d'applications, essentiellement par enduction, au pinceau ou à la brosse, en fonction de la fluidité du matériau de base au moment de l'application : l'épaisseur déterminée par les conditions d'étalement des matériaux essayés s'est avérée convenir pour l'obtention des résultats recherchés.

La figure 2 illustre l'application de l'invention à un conducteur isolé : le conducteur 1 portant ici une gaine isolante 4, c'est sur la surface externe de cette gaine qu'est déposée une couche enrobage 5 conforme à l'invention.

S'agissant par exemple d'un câble isolé au PVC, le matériau de base adapté dans l'enrobage était également du PVC.

Un problème particulier se pose aux extrémités dénudées telles que 2 d'un tronçon du fil traité selon l'invention. Au dénudage des extrémités la gaine isolante 4 étant sectionnée par un instrument tranchant quelconque, cette opération rompt la continuité de la surface avec la possibilité de formation de discontinuités plus ou moins pointues que l'expérience révèle comme étant nuisibles aux résultats recherchés selon la présente invention. Ces nuisances sont évitées selon la disposition consistant à recouvrir la partie terminale de la gaine isolante enrobée 4-5 par un enrobage d'extrémité 6, par exemple en vernis cellulosique déposé au pinceau, qui, après séchage, assure une continuité de la surface depuis la partie courante de l'enrobage 5 jusqu'à la partie terminale dénudée 2 du conducteur.

Cet enrobage d'extrémité à base de vernis cellulosique par exemple peut éventuellement comporter une charge de matériau semi-conducteur comparable à la charge du matériau de l'enrobage courant 5.

Dans ce cas l'enrobage d'extrémité 6 remplit simultanément deux fonctions : outre le lissage de la surface que l'on vient de considérer, ledit enrobage d'extrémité établit alors une liaison électrique entre la couche d'enrobage courant, d'une part, et le conducteur, d'autre part, qui se trouvent normalement séparés électriquement par la gaine isolante 4.

Or, une telle liaison s'avère nécessaire de place en place pour assurer le drainage selon l'invention de charges susceptibles de s'accumuler dans la couche d'enrobage 5.

Si un tel drainage est donc possible au moyen de l'enrobage d'extrémité 6, l'expérience montre cependant qu'il est désirable de le doubler par sécurité au moyen d'une autre liaison de drainage ménagé à cet effet à proximité de l'extrémité, comme illustré en 7 sur la figure 2 : il s'agit d'une entaille creusée dans la gaine isolante 4 et l'enrobage 5 à une faible distance (de quelques centimètres par exemple) de l'extrémité dénudée et de la disposition dans cette entaille d'une goutte de colle infiltrante (du type "Cyanolit" par exemple) chargée de semi-conducteur dans les mêmes proportions que le matériau d'enrobage courant.

Grâce aux propriétés de la colle infiltrante la liaison avec un point du conducteur demeure ainsi assurée même en cas de fissuration, voire destruction plus ou moins complète de l'enrobage terminal sous les contraintes mécaniques auxquelles il peut se trouver exposé.

La figure 3 montre une variante de la liaison de drainage ainsi que des dispositions à prendre selon l'invention à la jonction entre deux tronçons de câble.

La liaison de drainage 7A, prévue encore à proximité d'une extrémité dénudée 2 protégée par un enrobage d'extrémité 6, est constituée ici en ménageant une gorge annulaire d'interruption de la continuité de la gaine isolante 4, tandis que l'enrobage 5 se poursuivant sur la surface de cette gorge vient au contact du conducteur au niveau du fond de celle-ci.

Au niveau du raccordement des deux tronçons de câble a et b illustrés à la figure 3, alors que la jonction entre tronçons de conducteurs dénudés est réalisée par exemple au moyeu d'une soudure indiquée en 8, la continuité de l'isolation est rétablie au moyen d'une masse d'enrobage 9 semblable à l'enrobage d'extrémité 6. Dans ce cas, bien entendu, il s'agira nécessairement d'un enrobage chargé de semi-conducteur afin que la continuité de l'enrobage 5 soit assurée. Du même coup on réalise à cet endroit une liaison de drainage avec le conducteur, de sorte que si le raccordement est relativement proche de l'extrémité 2, c'est-à-dire que si le tronçon de câble a est relativement court, il devient inutile de prévoir la liaison de drainage 7A.

On a supposé dans ce qui précède que le matériau liant de base de l'enrobage 5 (par exemple PVC) était compatible sans problème avec la matière de la gaine isolant 4 du câble à protéger. Cette condition n'est pas toujours réalisée. Ainsi, lorsqu'on a cherché à appliquer l'invention à un câble isolé au PTFE, on s'était heurté à la difficulté de faire adhérer à ce matériau un revêtement quelconque.

Aussi s'est-on trouvé dans ce cas amené à recourir à un traitement de surface préalable de la gaine isolante afin de rendre possible la solidarisation de celle-ci avec un enrobage selon l'invention. Ce traitement de surface répond d'ailleurs au problème général bien connu des collages sur des objets en PTFE et peut se réaliser de diverses manières, par exemple par voie chimique avec une solution de sodium dans l'ammoniac liquéfié. On sait que ces traitements par exemple chimiques, ont pour effet de provoquer une transformation moléculaire de la couche superficielle de l'objet en PTFE soumis au traitement.

Or, il a été constaté de manière surprenante qu'un tel traitement appliqué à un câble isolé au PTFE n'avait pas seulement pour effet de rendre possible l'adhérence d'une couche d'enrobage du genre décrit : avant même la pose d'un tel enrobage le câble ayant subi le traitement préparatoire offre déjà à un degré notable l'effet de protection recherché selon la présente invention. On est amené ainsi à admettre que la couche superficielle de la gaine en PTFE ayant subi le traitement de modification de sa structure moléculaire est de nature à jouer dans une certaine mesure le rôle d'enrobage protecteur selon l'invention.

Après avoir décrit ainsi diverses modalités d'application du procédé selon l'invention à la protection d'un quelconque conducteur nu ou isolé, on va considérer maintenant une application du même procédé général à la protection d'un haut parleur, élément essentiel d'installations électroacoustiques qui a entre autres la particularité de se trouver par définition en interaction active avec l'air ambiant.

Selon la forme de réalisation choisie et représentée, il s'agit d'un haut-parleur électrodynamique 10 comprenant de manière usuelle un châssis 11 de forme tronconique largement évidée avec à sa grande base une lèvre périphérique 12 de support de membrane et à sa petite base le moteur formé par le circuit magnétique avec culasse 13, aimant annulaire 14a, aimant axial 14b, et bobine mobile 15 portée par son support cylindrique 16 et reliée à un bornier 17. La membrane 18 est reliée par une suspension antérieure 19 à la lèvre 12 et par une suspension postérieure 20 à la petite base du châssis; elle est fermée en outre, en regard du support 16 de la bobine mobile auquel elle est raccordée, par un dôme 21 en forme de calotte sphérique.

Selon une disposition de l'invention ce dôme est percé au centre d'un trou adapté à recevoir par collage ou soudage un tronçon de tube métallique 22 de faible diamètre, d'environ 2mm par exemple, s'étendant selon l'axe central de la membrane sur une distance de l'ordre du centimètre. L'extrémité libre 23 de ce tube fin et léger (en alliage léger par exemple) est avantageusement effilée pour les raisons qui apparaîtront ci-après.

La membrane est percée enfin d'au moins deux trous 24 symétriquement disposés de part et d'autre de l'axe central précité qui se confond d'ailleurs avec l'axe principal du circuit magnétique.

Le traitement selon l'invention d'un haut-parleur ainsi constitué comporte la disposition de deux enrobages distincts de la partie mobile d'une part et de la partie fixe d'autre part.

L'enrobage de la partie fixe désignée par la référence 25 s'étend sur toutes les faces externes du circuit magnétique et du châssis 11 jusqu'aux deux suspensions 19,20 et à l'exclusion de celles-ci. Le drainage s'opère par raccordement du fil de masse arrivant au bornier 17. La réalisation de l'enrobage a été effectué après montage du haut-parleur par enduction avec un mélange polymérisable in situ.

L'enrobage de la partie mobile réalisé avant montage du haut-parleur s'effectue par trempage de la membrane 18 préparée à cet effet de sorte que l'enveloppe s'étende sur les deux faces interne et externe de la membrane ainsi que sur la paroi interne du tube axial 22, mais non pas sur la paroi externe de celui-ci, ni sur les suspensions 19 et 20. Ainsi l'enrobage 26A de la face externe de la membrane est en communication avec l'enrobage 26B de la face interne laquelle se poursuit sur la paroi interne du tube axial 22 jusqu'à l'extrémité effilée 23 de celui-ci.

L'expérience montre que les performances qualitatives d'un haut parleur ainsi aménagé sont considérablement améliorées. Le drainage de l'enrobage 26 est assuré par effet de pointe à l'extrémité libre effilée du tube axial 22. La disposition de ce tube dans l'axe de symétrie du circuit magnétique procure semble-t-il une régularisation des interactions avec le milieu environnant, régularisation favorisée par le fait que la paroi externe du tube électriquement conducteur soit dénudée et constitue le seul élément conducteur placé au contact direct du milieu environnant. Enfin la communication établie à travers le tube axial entre l'espace confiné à l'arrière de la suspension interne 20, d'une part, et l'atmosphère, d'autre part, constitue également un facteur favorable au bon comportement du haut-parleur, notamment aux charges élevées.

La figure 5 illustre enfin un exemple d'application de l'invention au traitement d'un circuit acoustique 30 du genre décrit dans la demande de brevet précitée avec un socle 31, une ossature verticale 32, supportant un haut-parleur 10 du type précédemment décrit en référence à la figure 4, ainsi qu'un haut-parleur d'aigus ou tweeter désigné par la référence 10A.

A la face inférieure d'une paroi horizontale 33 portant le haut-parleur 10 dirigé ici vers le haut est raccordé autour d'un manchon de support 34 un tronçon de tuyau souple 35 s'étendant sur la hauteur de l'enceinte, munie d'une armature hélicoïdale 36 et doublé à son extrémité inférieure, par un manchon rigide 37 rempli d'une masse 38 de matériau absorbant en l'occurrence de l'ouate de cellulose. La référence 40 désigne le câble d'alimentation du haut-parleur 10 qui s'étend à partir du bornier 17 dudit haut-parleur à l'intérieur du tuyau 35, traverse un tube guide inférieur 39 puis un passage 41 ménagé à cet effet dans le socle 31 et aboutit à un boîtier 42 de raccordement. La référence 44 désigne le câble d'alimentation du haut-parleur d'aigus 10A qui partant du même boîtier 42 s'étend à l'extérieur du tuyau 35 et porte de manière usuelle un condensateur 45 monté en série. La référence 46 désigne le câble allant du boîtier 42 vers un amplificateur d'alimentation.

L'ossature verticale 32 que est largement évidée, étant réduite par exemple à quatre montants est habillée d'une peau d'habillage 47 généralement un tissu approprié.

Le traitement d'une telle enceinte selon la présente invention comporte de manière générale la disposition d'un enrobage protecteur du genre décrit sur l'ensemble des surfaces exposées à l'atmosphère environnante.

Selon la forme de réalisation illustrée, un tel enrobage s'étend ainsi en 35A sur la paroi interne et en 35B sur la paroi externe du tuyau souple 35 ; l'enrobage 35A se poursuit sur la paroi externe du manchon inférieur 37, autour du tube guide inférieur 39, sur les diverses parois assemblées du socle 31, puis en 47A sur la face externe de la peau 47 ; il se poursuit également en 34A à l'intérieur du manchon de support supérieur 34 pour rejoindre l'enrobage 25 précédemment décrit du haut-parleur principal 10.

Cet enrobage général est également étudié, comme indiqué en 48 autour de la structure supérieure du support du haut-parleur d'aigus 10A, ainsi que sur la partie fixe de ce dernier, comme indiqué en 49.

Pour l'ensemble de cet enrobage de l'enceinte et des parties fixes des haut-parleurs, il est avantageusement prévu un unique point de drainage situé au bornier 17 du haut-parleur principal 10 lequel est à son tour relié à une masse appropriée de l'installation par exemple par le fil de retour à la masse du câble d'alimentation 40 de ce haut-parleur, éventuellement le blindage de ce câble.

Cependant, selon une disposition additionnelle de l'invention ce câble d'alimentation (40) lui-même est soigneusement isolé du reste de l'installation par la disposition autour de ce câble d'une gaine en PTFE pur, cette gaine pouvant être un tronçon de gaine tubulaire dans lequel le câble d'alimentation peut passer librement. Il en est de même du câble 44 d'alimentation du haut-parleur d'aigus 10A : cette disposition, éventuellement étendue raussi au câble d'alimentation 46, est destinée à éviter tout risque d'interaction nuisible notamment par des contacts des conducteurs avec de quelconques parties de l'enceinte.

Les dispositions décrites dans le cadre d'applications relevant du domaine électroacoustique semblent avoir une portée généralisable en fonction des hypothèses de départ à tous autres domaines de traitement de signaux quelconques. Il convient de noter par ailleurs que les performances obtenues dans les cas d'applications essayées à ce jour, semblent être favorisées par le caractère lisse de la surface de l'enrobage.

## Revendications

1. Procédé de protection d'un élément d'installation plongé dans un milieu environnant, en particulier l'air ambiant, et sensible aux influences électriques, magnétiques et/ou électromagnétiquess de ce milieu, caractérisé par la disposition autour dudit élément d'un enrobage destiné à assurer un drainage des charges électriques tendant à s'y accumuler, cet enrobage étant constitué par application sur l'élément à protéger d'un revêtement en matériau isolant chargé d'un matériau semi-conducteur intrinsèque.

2. Procédé selon la revendication 1, caractérisé en ce que le matériau isolant est choisi dans un groupe comprenant le polyvinylchloroéthylène, le polyéthylène, le silicone.

3. Procédé selon la revendication 1 ou 2, caractérisé en ce que le matériau semi-conducteur est choisi dans une famille comprenant le sélénium, le germanium, le sulfure de plomb, les oxydes de fer, l'oxyde cuivreux.

4. Procédé selon la revendication 1, caractérisé en ce que l'élément protégé est un fil conducteur nu (1).

5. Procédé selon la revendication 1, caractérisé en ce que l'élément protégé étant un conducteur isolé (1), il est prévu des raccordements ponctuels (6, 7, 7a) de l'enrobage (5) au conducteur.

6. Procédé selon l'une quelconque des revendications 1 à 3, caractérisé en ce que l'élément protégé étant une enceinte acoustique (30) équipée d'au moins un transducteur (10), il est prévu au moins une zone (17) de l'enrobage située à proximité du ou des transducteurs reliée au moyen d'un conducteur de raccordement (40) à une masse.

7. Procédé selon l'une quelconque des revendications 1 à 3, caractérisé en ce que l'élément protégé étant une membrane (18) de haut-parleur (10) et un enrobage (26A, 26B) étant disposé sur les deux faces de cette membrane, ces enrobages sont en communication avec un organe central de décharge par effet de pointe (23).

8. Haut-parleur traité selon la revendication 7, caractérisé en ce que l'organe central de décharge est constitué par un tronçon de tube métallique de petit diamètre fixé au centre de la membrane (18) selon l'axe du circuit magnétique du haut-parleur, l'enrobage étant étendu sur la surface interne, mais non pas externe, de ce tube, et au moins deux perçages (24) symétriquement disposés de la membrane établissant une communication entre les deux faces de celle-ci.

9. Application du procédé selon la revendication 1, à un conducteur isolé, caractérisé en ce que l'isolant (4) étant à base de PTFE (5) l'enrobage comporte un traitement de transformation chimique d'une couche superficielle de cet isolant, en particulier avec une solution de sodium dans l'ammoniac liquéfié.

## Claims

1. A method of protection of an element of installation immersed in a neighbouring medium, in particular, the surrounding atmosphere, and susceptible to the electric, magnetic or electromagnetic influence of that medium, characterised by the provision around the element of a coating element for ensuring the drainage of electric charges tending to accumulate thereon, this coating being constituted by the application to the element to be protected of an insulating material loaded with an intrinsic semi-conductive material.

2. A method according to claim 1, characterised in that the insulating material is selected from the group comprising polyvinylchloroethylene, polyethylene and silicone.

3. A method according to claim 1 or 2, characterised in that the semi-conductive material is selected from the family comprising selenium, germanium, lead sulphide, iron oxides and cuprous oxide.

4. A method according to claim 1, characterised in that the protected element is a bare conductive filament (1).

5. A method according to claim 1, characterised in that the protected element is an insulated conductor (1) which is provided with limited links (6,7,7a) from the coating (5) to the conductor.

6. A method according to any of claims 1 to 3, characterised in that the protected element is an acoustic enclosure (30) having at least one transducer (10), provided with at least one coated region (17) situated near the transducer or transducers linked by means of an integral connector (40).

7. A method according to any of claims 1 to 3, characterised in that the protected element is a membrane (18) of a loudspeaker (10) and a coating (26A,26B) is disposed on the two faces of this membrane, these coatings being in communication with a central point discharge member (23).

8. A loudspeaker treated according to claim 7, characterised in that the central discharge member is constituted by a section of metallic tube of small diameter fixed to the centre of the membrane (18) in conformity with the magnetic axis of the loudspeaker, the coating extending over the internal surface but not the external surface of this tube, and at least two bores (24) are symmetrically disposed in the membrane establishing a connection between the two faces thereof.

9. The application of the method according to claim 1 to an insulated conductor, characterised in that the insulator (4) is based on PTFE (5) and the coating comprises a chemical treatment of a superficial sheath on the insulator, in particular with a solution of sodium in liquid ammonia.

**Patentansprüche**

1. Verfahren zum Schutz eines Installationselements, das in ein umgebendes Medium, insbesondere die umgebende Luft getaucht ist, und das gegenüber den elektrischen, magnetischen und/oder elektromagnetischen Einflüssen dieses Mediums empfindlich ist, dadurch **gekennzeichnet,** daß um das Element eine Umhüllung angeordnet wird, die dazu bestimmt ist, sich dort ansammelnde elektrische Ladungen abzuführen, wobei die Umhüllung dadurch gebildet wird, daß an dem zu schützenden Element ein Überzug aus isolierendem Material angebracht wird, welches von einem eigenleitenden Halbleitermaterial durchsetzt ist.

2. Verfahren nach Anspruch 1, dadurch **gekennzeichnet,** daß das isolierende Material aus einer Gruppe gewählt ist, die Polyvinylchloroäthylen, Polyäthylen und Silikon umfaßt.

3. Verfahren nach Anspruch 1 oder 2, dadurch **gekennzeichnet,** daß das Halbleitermaterial aus einer Familie ausgewählt ist, die Selen, Germanium, Bleisulfid, die Eisenoxide und Kupferoxid umfaßt.

4. Verfahren nach Anspruch 1, dadurch **gekennzeichnet,** daß das zu schützende Element ein blanker Leiterdraht (1) ist.

5. Verfahren nach Anspruch 1, dadurch **gekennzeichnet,** daß das zu schützende Element ein isolierter Leiter (1) ist, und daß punktweise Verbindungen (6, 7, 7a) der Umhüllung (5) mit dem Leiter vorgesehen sind.

6. Verfahren nach einem der Ansprüche 1 bis 3, dadurch **gekennzeichnet,** daß das zu schützende Element eine Schallwand (30) mit zumindest einem Wandler (10) ist, und daß zumindest eine Zone (17) der Umhüllung vorgesehen ist, die in der Nähe des oder der Wandler angeordnet und mittels eines Verbindungsleiters (40) mit einer Masse verbunden ist.

7. Verfahren nach einem der Ansprüche 1 bis 3, dadurch **gekennzeichnet,** daß das zu schützende Element ein Membran (18) eines Lautsprechers (10) ist, und daß eine Umhüllung (26A, 26B) auf den beiden Seiten dieser Membran angeordnet ist, wobei diese Umhüllungen mit einem zentralen Entladungsorgan durch einen Punkteffekt (23) in Verbindung stehen.

8. Lautsprecher, der nach Anspruch 7 behandelt ist, dadurch **gekennzeichnet,** daß das zentrale Entladungsorgan durch einen Abschnitt einer metallischen Röhre kleinen Durchmessers gebildet ist, der am Zentrum der Membran (18) gemäß der Achse des Magnetkreises des Lautsprechers fixiert ist, wobei die Umhüllung flach auf der inneren Fläche der Röhre, jedoch nicht auf der äußeren liegt, und zumindest zwei Bohrungen (24) vorgesehen sind, die bezüglich der Membran symmetrisch angeordnet sind und eine Verbindung zwischen deren beiden Flächen herstellt.

9. Anwendung des Verfahrens nach Anspruch 1 bei einem isolierten Leiter,
dadurch **gekennzeichnet,**
daß ein Isoliermaterial (4) auf der Basis von PTFE (5) vorgesehen ist, und daß die Umhüllung eine Behandlung mit einer chemischen Umwandlung einer Randschicht des Isoliermaterials, insbesondere mit einer Natriumlösung in verflüssigtem Amoniak umfaßt.

FIG. 1

FIG. 2

FIG. 3

FIG. 4

FIG. 5